# EUROPEAN PATENT SPECIFICATION

(11) **EP 0 636 282 B1**
(45) Date of publication and mention of the grant of the patent: **19.06.1996**
(21) Application number: 93904007.7
(22) Date of filing: 23.02.1993
(51) Int. Cl.: H01S 3/05, H01S 3/094, H01S 3/16, G02B 6/42

(54) **LASER DEVICE**
LASERVORRICHTUNG
DISPOSITIF LASER

(30) Priority: 17.04.1992 IT MI920943
(43) Date of publication of application: 01.02.1995
(73) Proprietor: ITALTEL SOCIETA ITALIANA TELECOMUNICAZIONI s.p.a., I-20149 Milano (IT)
(72) Inventor: CHIARETTI, Guido, I-20026 Novate Milanese (IT); DI ROCCO, Daniele, I-20053 Muggiò (IT); LAPORTA, Paolo, I-20090 Segrate (IT); SVELTO, Orazio, I-20090 Segrate (IT)
(74) Representative: Giustini, Delio
(86) International application number: EP9300421
(87) International publication number: WO9321670

(56) References cited:
- EP-A- 0 358 410
- US-A- 4 797 893
- US-A- 4 942 582
- US-A- 5 077 747
- ELECTRONICS LETTERS. vol. 28, no. 5, 27 February 1992, ENAGE GB pages 490 - 492, XP000292696, P.LAPORTA et al.: "High-power and high-efficiency diode-pumped Er:Yb:glass laser"
- OPTICS LETTERS. vol. 15, no. 8, 15 April 1990, NEW YORK US pages 440 - 442 , XP000114071 J.A.MORRIS 'Passive Q-switching of a diode-pumped Nd:Yag laser with a saturable absorber'
- OPTICS LETTERS. vol. 16, no. 15, 1 August 1991, NEW YORK US pages 1171 - 1173 , XP000226356 J.M.AUERBACH ET AL. 'Diode-laser-pumped monolithic Nd:YLF laser operating at 1.053 um'
- JOURNAL OF APPLIED PHYSICS. vol. 45, no. 1, January 1974, NEW YORK US pages 201 - 208 J.C.VANDERLLEDEN 'Resonant cavities with mirrors made from graded-index rods'

## Description

### Technical Field

The present invention refers to a laser device to be employed as continuous source of a single mode, monochromatic radiation in telecommunications, of the type including an active medium capable to emit a radiation at a first wavelength λ1, pumped by a laser capable to emit a radiation at a second wavelength λ2 < λ1.

### Industrial Applicability

The device according to the invention has application in telecommunication systems and particularly it can be profitably employed, but not only, as continuous source at the frequency of 1.54 µm (the so-called third window) for coherent transmission in optical fiber.

For optical fiber telecommunications future developments it is foreseen the use of a radiation having 1,54 µm (1540 nm) wavelength corresponding to the so-called third window to which optical fibers for telecommunications present a reduced attenuation.

A coherent light source for this use has to supply a sufficiently high output power, in the range of some mW to have practical applications, with single mode type emissions and with a width of the emitted spectrum line to be as reduced as possible.

As an example, current sources of this kind are realized with single mode, DFB semiconductor laser, having typical optical powers of 1-4 mW in single mode fiber and 1-30MHz linewidth.

### Background Art

To obtain sources capable to produce the required wavelength, it was proposed as active medium the so-called glass lasers, that is including an Erbium (Er) doped glass. Two additional laser devices are employed as pump source, and particularly a semiconductor laser having 808 nm wavelength pumping a neodymium laser, which in its turn emits a 1060 nm radiation pumping the glass laser capable to emit the laser radiation at the desired wavelength of 1.54 µm.

Said glass lasers contain also a given ytterbium (Yb) percentage having the scope to increase the pumping yield since Ytterbium has an absorption band wider than the Erbium one, then transferring to this last the power absorbed.

This device requires a double conversion and also the neodymium emission yield is very low (in the range of 1-2%), so as to render critical the operation of the device, therefore even minimum losses of the laser cavity can cause a poor output power, so that use has to be made of very accurate and expensive processing of the most critical components.

In the paper "Diode-pumped CW Bulk Er:Yb: glass laser" by P. Laporta et. al., OPTICS LETTER, Vol. 16, no. 24, December 15, 1991, it was proposed to pump directly the glass laser through a semiconductor laser emitting at 980 nm, focusing the pumping radiation on the glass laser with a traditional optical system. The optical resonator cavity is defined between a surface coating of the glass element, which is essentially transparent to the 980 nm radiation and highly reflecting to the 1.54 µm radiation and a 1.54 µm reflecting curve mirror.

Since the light emitted by the glass laser is a multimodal one, a so-called etalon, that is a glass sheet having adequate thickness determining the elimination of undesired propagation modes, as to obtain a single mode laser having narrow emission line, is placed between the glass laser and the mirror.

This device, even if effective from the conceptual point of view, has no practical application in telecommunication systems due to its large dimensions, associated costs, difficult setting for the etalon calibration, so there is a need to realize a laser source having reduced dimensions, limited cost, high output power and very narrow spectrum line.

These devices, even if effective from the conceptual point of view, have no practical application in telecommunication systems due to its large dimensions, associated costs, difficult setting for the etalon calibration, so there is a need to realize a laser source having reduced dimensions, limited cost, high output power and very narrow spectrum line.

Electronics Letters, vol. 28, No. 5, pages 490-492 discloses a laser device as recited by the preamble of claim 1 which provides for a focusing and reshaping optics coupling the pump diode laser with the active portion and a solid etalon in the second portion of focusing optical guide.

### Object of the Invention

The object of the present invention is to overcome the above mentioned drawbacks and limits, and particularly to realize a device having an output linewidth lower than one hundred kHz (compared to the values of 1-30 M Hz of known DBF single mode lasers at this wavelength).

### Disclosure of Invention

According to the invention, the scopes are attained with a laser device to be employed as continuous source of a single mode, monochromatic radiation at a first wavelength λ1 in telecommunications, comprising:
- a pump diode laser capable of emitting a radiation at a second wavelength λ2 < λ1
- a solid-state active medium capable of emitting a radiation at said first wavelength λ1, coupled to said pump laser through a first focusing optical guide, between the second face of said first focusing optical guide and the first face of said active medium being placed a first filter essentially transparent to said radiation λ2 and essentially reflecting said radiation λ1, to the second face of said active medium being applied a second filter (5) essentially transparent to said radiation λ1 and essentially reflecting said radiation λ2;
- an etalon interposed between said first filter and a third filter partially reflecting radiation at said first wavelength λ1;
   characterized in that
- said laser device consists of a single structure mounted on support means,
- said etalon is formed as an air gap of adjustable width, placed between said first filter and said third filter, a member being provided in said support means to vary the width of said air gap;
- a second focusing optical guide of the graded index type consisting of at least a first portion whose first end is optically coupled to said second filter and whose second end is coated by said third filter; and a first portion of optical fiber coupled to said third filter or to a second portion of the second focusing optical guide.

Embodiments of the invention are set out in the appended dependent claims.

### Brief Description of the Drawings

The invention, together with further objects and advantages thereof, may be understood with reference to the following description, taken in conjunction with the accompanying drawings and in which:
figures 1 A and 1B schematically show a first and a second realization form of the device realized according to the present invention;
figure 2 shows a construction drawing of the device according to this invention, carried out according to said second realization form (figure 1B);
figures 3A and 3B schematically show a third and a fourth realization of the device according to this invention;
figure 4 shows a construction drawing of the device according to the present invention, realized according to said fourth realization form (figure 3B);
figures 5 to 8 schematically show four realization forms of the device according to the present invention.

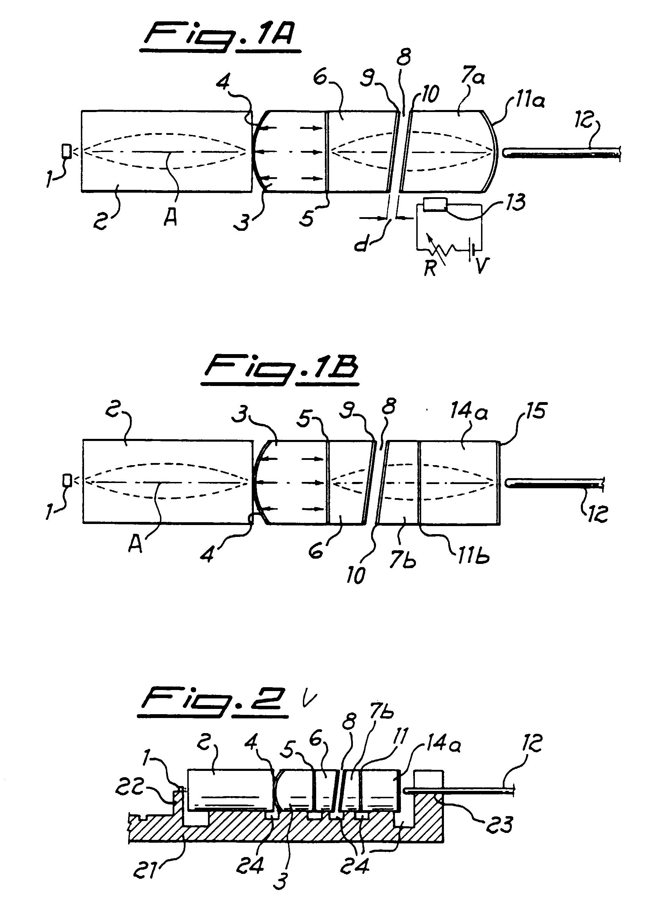

With reference to figure 1 A, the device according to the invention includes a first semiconductor laser 1 which, according to a preferred realization form, emits radiations at a wavelength between 960 and 980 nm and is optically coupled to a monolithic structure having continued form and preferably with circular cross section.

The structure includes a focusing guide 2, made according to a preferred realization form of a so-called SELFOC lens that is essentially a segment of optical guide of the graded refraction index type, having length equal to P/2, such to focus a radiation beam incoming from the front face on a spot of the opposite end surface. P is the so-called focusing pitch, that is the distance between the two contiguous planes for the formation of identical images.

An active portion 3 which according to the realization form here described is preferably, but not limitedly, made of Ytterbium and Erbium doped glass, butt coupled to this focusing surface. The said surface of this active portion 3 is prefereably rounded with a concave side towards the active material (as shown in figures 1, 2 and 3A), to focus radiations emitted by the pumping laser 1 and to facilitate the excitation of the fundamental mode. However, according to the invention, this surface can have a flat configuration as shown in the remaining figures.

This surface is coated with a layer 4 which is highly transparent to the pumping radiation λ2 = 960 - 980 nm and highly reflecting to laser radiation λ1 = 1.54 µm emitted by the active material 3. The opposite surface of the active material 3 is also coated by a layer 5 highly reflecting the pumping radiation λ2 and transparent for the λ1 radiation emitted by the same active medium 3. Layers with these characteristics are obtained, in the known manner, with the depositing of layers of appropriate oxides or metals.

The laser radiation λ1 = 1.54 µm emitted by the active portion (laser) 3 passes through the first part or segment of a pair of additional SELFOC lenses 6 and 7a, axially aligned and separated by an air gap 8 having an adjustable axial width d. The opposing faces of said pair of lenses 6 and 7a show, according to a preferred realization form, the surfaces 9 and 10 coated by layers reflecting the radiation λ1 emitted by the active medium. The second part or segment 7a, in the realization form shown in Fig. 1, has a curved end surface, in particular that of a half-sphere and this surface has a coating or mirror lla highly reflecting to laser radiation λ1 = 1.54 µm emitted by the active medium 3. The total length of the pair of lenses 6, 7a plus the air gap d is approximately equal to 1/2 P and therefore is such as to focus the laser radiation 3 in a limited axial area matching the mirror lla. The optical radiation coming out from the active medium (laser) 3 is therefore partially reflected backwards by the reflecting surface 11a and refocused by this one, with an essentially similar path, on the second face 5 of the active portion (laser) 3, while the transmitted portion of the optical power crossing the layer 11a (poorly transparent) forms the useful laser radiation which is coupled through a single mode optical fiber 12, to an external modulator or other guide and modulation device (not shown). The system of lenses 6 and 7a, of the active portion 3 and of the reflecting layers 4 and 11 forms the resonator cavity of the glass laser which is therefore limited by said surface 4 and by said mirror 11.

Furthermore, according to the invention, the two portions 6 and 7a are separated by an air gap 8, representing a discontinuity of the refraction index in the axial direction (becoming an approximately unit value if air is present in the cavity) and acts as an etalon. This etalon, whose surfaces 9 and 10 are preferably coated with layers reflecting the λ1 =1.54 µm radiation, has the function to suppress the unwanted modes so as to obtain a single mode laser having a narrow output line. The air space 8, according to additional realization forms described hereafter, can be foreseen in whichever position included in said surface 4 and said mirror 11.

To select one mode a piezoelectric element 13 is foreseen, driven by an adjustable voltage supply through a variable resistence R allowing the distance d to be changed and thus obtain the desired shifts (in the range of one tenth of a micron) to form an etalon with the desired features.

According to a further realization form shown in figure 1B, the total length of the pair of lenses 6 and 7b plus the air gap d is equal to approximately 1/4 P and the end surface of the end portion 7B is flat and coated by a flat mirror 11b surrounding the resonator at 1.54 µm, while the operation is essentially equivalent to that shown in figure 1A. In particular, since the layer 11b is weakly transparent, radiation passing through this layer is focused by an additional optical guide segment 14a, approximately 1/4 P long, whose end face is coated by an anti-reflecting surface 15 to the radiation λ1 = 1.54 µm. A length of optical fiber 12 is coupled to said further optical guide segment 14a, similar to that shown in figure 1B.

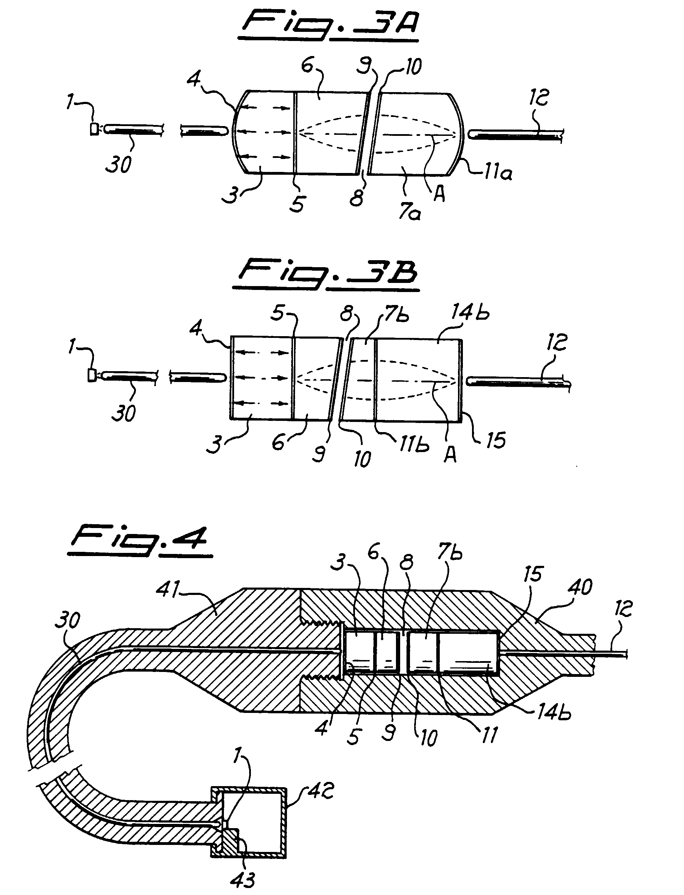

Figure 2 shows a construction drawing of the device according to the present invention and in particular it shows the above mentioned monolithic structure, positioned on a submount 21, sectioned to better highlight the positioning of said structure versus the laser diode 1 and the fiber 12.

In particular the submount 21 consists of a rectangular section steel guide having at one end a lifted portion 22 on which the laser 1 is welded and having at the other end a "V" shaped housing 23 where the fiber 12 is installed and fixed with glue.

Between the lifted portion 22 and the housing 23, housings are foreseen, separated by cavities 24, showing a form complementary to that of said first focusing element 2, active portion (laser) 3, second focusing element 6 and 7b.

We can see that between selfoc lenses 6 and 7b an air gap forming the etalon 8 showing the reflecting surfaces (9 and 10) the radiation λ1 emitted by the active portion (laser) 3, is interposed.

The piezoelectric element 13 is not shown here in order not to unusefully complicate the drawing.

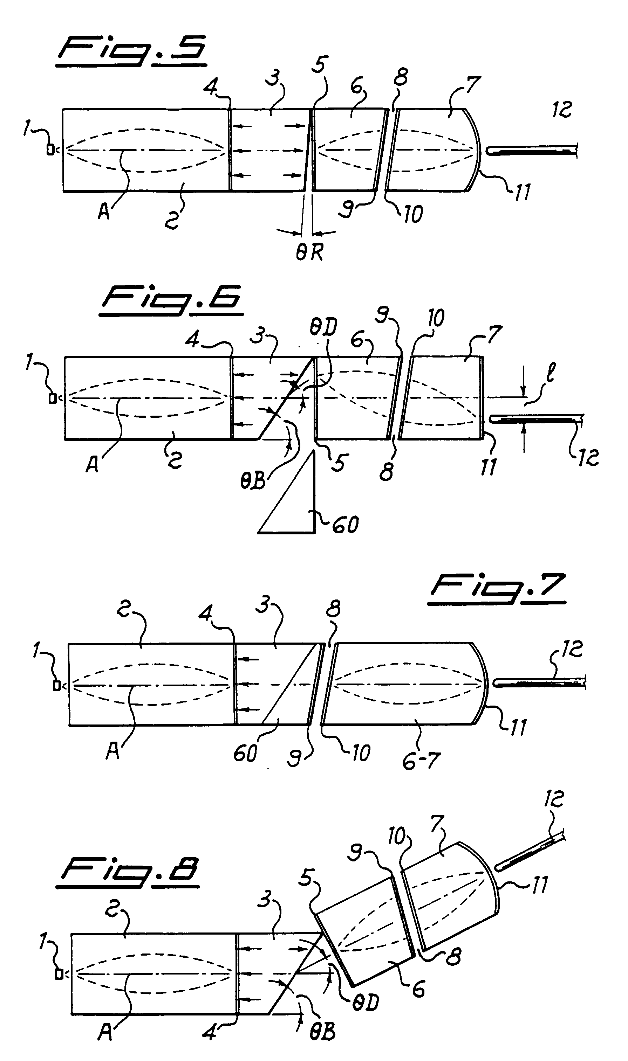

Figure 3A shows a third realization form of the device according to the invention, differing from the previous ones due to the fact that the first segment of optical-guide 2 is replaced by a length of optic fiber 30 suitable to couple the laser 1 to said active portion (laser) 3. The remaining portion of the monolithic structure is entirely similar to the one shown in figure 1A.

Figure 3B shows a fourth realization form of the device according to the invention employing the same length of optical fiber 30 previously shown in figure 3A and differing from said third realization form due to the fact that the first face of the active portion is flat and to the fact that the selfoc lens 7a - having a curved end surface is replaced by a lens 7b - having a flat end portion and coupled to an additional optical guide segment (selfoc lens) 14b, similar to that shown in figure 1B.

Figure 4 shows a construction drawing of said fourth realization form (see figure 3B) of the device according to the invention where it can be see that said monolithic structure is enclosed inside the female portion 40 of a connector for optical fiber systems. Similar to as shown in figure 3B the active portion (laser) 3 is coupled to the remaining part of the resonator made up of the portions of optical guide 6 and 7b in cascade to which, a further focusing optical guide portion 14 b is foreseen: a pig-tail 12 is coupled to said portion 14b.

The optical fiber 30 is on the contrary inclosed in the male portion 41 of the connector for optical fiber systems, and in this way one end of fiber 30 can be coupled to said active portion (laser) 3.

The second end of fiber 30 is connected to a box body 42 inside which a submount 43 capable of supporting the pumping laser 1 is housed.

Figure 5 shows a fifth realization form of the device according to the invention repeating the same arrangement of elements previously described in figure 1A with the sole exception that the second face of the active medium 3 is angled with respect to the first face at an angle θR whose value is approximately 1°. This fifth realization form has an advantage over the realization forms previously described when it is deemed useful to eliminate reflections of radiation generated by the second face of said active portion.

Obviously it is possible to use an active portion 3, shaped as shown in figure 5, combined with the element shown in figures 3A and 3B (the selfoc lens 2 is replaced by an optical fiber 30) as well as being combined with the elements shown in figure 1B (that is combined with a group of lenses 6 and 7b plus etalon 8 having a total length equal to approximately 1/4 P plus an additional length of focusing optical fiber 14b having total length equal to approximately 1/4P).

Figure 6 shows a sixth realization form of the device according to the invention differing from said fifth realization form due to the fact that the second face of the active portion 3 is angled with respect to the first face by an angle θB having a value equal to the Brewester angle (equal approx. to 34°). The slope of said second face of the active portion 3 according to the above mentioned angle θB allows linearly polarized radiation to be obtained, that is radiation along one polarization plane. This characteristic is advantageous when the radiation guided in the optical fiber 12 is modulated. In fact, if this radiation is linearly polarized, the modulator is capable of using 100% of the associated power.

The slope of the second face of the active medium 3 determines a deviation θD of optical signals with respect to the optical axis A and consequently said radiations are incident on the first face of said second segment of optical guides 6 and 7 in a position deviating by a predetermined quantity 1 with respect to the optical axis. As a consequence, these radiations are focused on the second face of said segment of optical fiber in a position shifted by the same quantity and in the opposite direction to the previous one with respect to the optical axis. Fiber 12 is consequently positioned of the focusing point at said distance 1 of the optical axis. In this case the length of lenses 6, 7 and etalon 8, equals approximately 1/2 P.

To prevent difficulties arising from the search of a focusing point not coinciding with the optical axis A, it could be convenient to insert a wedge shaped body 60, made of glass or active material, between said active portion and the second focusing optical guide, which determines the offset of said angle θD and consequently radiation having λ1 wavelength focuses on points coinciding with the optical axis. Fiber 12 has therefore to be positioned on the device optical axis.

Figure 7 shows a realization form of the device, shaped according to figure 6, that is with the wedge shaped body 60 housed in its position, but with etalon 8 placed between the active portion 3 and the second focusing optical guide 6-7. This solution has the advantage of allowing linearly polarized radiation to be obtained which can be coupled to an optical fiber 12 placed on the optical axis of the device and not requiring, at the same time, the cutting of selfoc 6 or 7 to realize the etalon 8 since this one is realized interposing an air gap between the wedge shaped body 60 and the selfoc lens 6 or 7.

An additional realization form allows a linearly polarized λ1 radiation to be obtained, which can be coupled to an optical fiber 12 arranged on the optical axis of the resonator portion is shown in figure 8. According to this solution, the resonator axis is at an angle θD with respect to the optical axis of elements 2 and 3.

Of course, the particular configuration of the second face of the resonator 3 (angle θB) as shown in figures 6 to 8 can be profitably applied to the laser device configuration previously shown in figures 3A and 3B (the optical guide portion 2 is replaced by an optical fiber 30), as well as making reference to the laser device configuration previously shown in figure 1B (the round mirror 11a is replaced by a flat mirror 11b).

The device according to the invention is of compact construction, with a size of about 4 cm³ compatible with the requirements of optical fiber telecommunication systems, and emitting a highly monochromatic radiation. Also it is simple to realize and of limited cost, complying with the above mentioned scope.

In the present description the invention has been shown making reference to the construction of a laser device including an active glass medium 3 - employing Erbium (Er) as a dopant and Ytterbium (Yb) as codopant, pumped by laser 1 operating between 960 - 980 nm approx. to obtain a device able to operate in the so-called third window.

However, the invention may be applied in other situations and particularly when combined with an active medium consisting of a glass matrix realized with different elements such as silicate, phosphate and fluorozirconate, doped with elements different from the above mentioned ones. In particular, the invention can also be profitably employed when combined with an active medium, consisting of a crystalline matrix, doped with elements differing from the above mentioned ones.

Said glass matrix can for instance employ:
A) Ytterbium as codoping element and Erbium or Praseodymium as doping elements, Yb3 + (Er, Pr);
B) Aluminium as codoping element and Erbium as doping elements, Al3 + (Er);
C) Lanthanium as codoping element and Erbium as doping elements, La3 + (Er);
D) Chromium as codoping element and Erbium, Thulium or Holmium as doping elements, Cr3 + (Er, Tm, Ho);
E) Mercury as codoping element and Neodymium as doping element, Mg2 + (Nd);
F) Thulium as codoping element and Holmium as doping element, Tm3 + (Ho);
G) Germanium as codoping element and Erbium or Praseodymium as doping elements, Ge4 + (Er, Pr).

We draw attention to the fact that for the specific field of telecommunication the following is of particular interest:
the use of doping and codoping elements mentioned under A, particularly Praseodymium and Neodymium, for the realization of a laser capable of emitting radiation at the 1.3 µm wavelength, that is in the so-called second window; the use of doping and codoping elements mentioned under D, particularly with Tm and Ho doping elements, for the realization of a laser capable of emitting radiation at approx. 2 µm wavelength, destined to be used combined with fibers for MIR applications, that is combined with fibers operating in the medium infrared and showing therefore an attenuation of about two orders of magnitude less than current fibers.
   The crystalline matrix can on the contrary employ for instance the following doping and codoping elements:
   - Er:CaF2 or Er:LiYF4 for the realization of a laser capable of emitting radiation at the 1.54 µm wavelength, that is in the so-called third window;
   - Nd:YAG or ND:YLF for the realization of a laser capable of emitting radiation at the 1.3 µm wavelength, that is in the so-called second window;
   Though the invention has been shown making reference to the preferred realization forms, it is generally subject to additions and modifications, as will be evident to a technician in this field.

## Claims

1. Laser device to be employed as continuous source of a single mode, monochromatic radiation at a first wavelength λ1 in telecommunications, comprising:
- a pump diode laser (1) capable of emitting a radiation at a second wavelength λ2 < λ1
- a solid-state active medium (3) capable of emitting a radiation at said first wavelength λ1, coupled to said pump laser (1) through a first focusing optical guide (2, 30), between the second face of said first focusing optical guide (2, 30) and the first face of said active medium (3) being placed a first filter (4) essentially transparent to said radiation λ2 and essentially reflecting said radiation λ1, to the second face of said active medium (3) being applied a second filter (5) essentially transparent to said radiation λ1 and essentially reflecting said radiation λ2;
- an etalon interposed between said first filter (4) and a third filter (11) partially reflecting radiation at said first wavelength λ1;
characterized in that
- said laser device consists of a single structure mounted on support means (21),
- said etalon is formed as an air gap (8) of adjustable width, placed between said first filter (4) and said third filter (11), a member (13) being provided in said support means (21) to vary the width of said air gap (8);
- a second focusing optical guide of the graded index type (6, 7, 14) consisting of at least a first portion (6, 7) whose first end is optically coupled to said second filter (5) and whose second end is coated by said third filter (11); and a first portion of optical fiber (12) coupled to said third filter (11) or to a second portion (14a) of the second focusing optical guide.

2. Device according to claim 1, characterized by the fact that a fourth and a fifth optical filter (9 and 10 respectively) reflecting said radiation λ1 are applied to the opposite faces of the elements forming said air gap (8).

3. Device according to claims 1 or 2, characterized by the fact that the second face of said active medium (3) is angled with respect to the first face by an angle (θR) whose value is approximately 1°. (figure 5)

4. Device according to claims 1 or 2, characterized by the fact that the second face of said active medium (3) is angled with respect to the first face by an angle (θB) whose value is equal to the Brewester angle. (figure 6)

5. Device according to claim 1, characterized by the fact that said first face of the active medium (3) is rounded, with the concave part towards the active material.

6. Device according to claim 1, characterized by the fact that said first face of the active medium (3) is flat.

7. Device according to claims 1 to 6, characterized by the fact that said second focusing optical guide (6, 7) is made up of one optical guide segment (6-7) with graded refraction index whose length is approximately P/2, P being the focusing pitch of the guide segment.

8. Device according to claims 1 to 6, characterized by the fact that said second focusing optical guide is made up of:
- one optical guide segment with graded refraction index (6, 7), whose length is approximately P/4, where P is the focusing pitch of the guide segment, and by the fact that said third filter (11) is coated to a flat face of the second end of this segment;
and of:
- a second optical guide segment with graded refraction index (14a) having length equal to approximately P/4;
- an anti-reflecting layer (15) coated to the second face of the second optical guide segment (14a).

9. Device according to claims 1 to 6, characterized by the fact that said first focusing optical guide is made of one optical guide portion (2) with graded refraction index, whose length is approximately P/2, where P is the focusing pitch of the guide segment.

10. Device according to claims 1 to 6, characterized by the fact that said first focusing optical guide is made up of a second portion of optical fiber (30). (figure 3).

11. Device according to claims 1 to 10, characterized by the fact that said member to adjust the width of said air gap (8) is combined to said second focusing optical guide (6, 7) and includes a piezoelectric element (13), driven by an adjustable supply voltage (R, V).

12. Device according to claim 4, characterized by the fact that the axis of said second focusing optical guide (6, 7) matches the axis of said active portion (3) and said first portion of optical fiber (12) deviates from the axis of said second focusing optical guides (6, 7) of a quantity (1) which is function of the angle (θD) of which optical signals deviate in consequence of the angle of the second face of said active portion (3) according to the Brewester angle and by the fact that said second focusing optical guides (6, 7) is nearly P/2 long, where P is the focusing pitch, and the second face is flat (figure 6).

13. Device according to claim 4, characterized by the fact that the axis of said second focusing optical guide (6, 7) is angled with respect to the axis of said active portion (3) by an angle equal to the angle (θD) deviating the optical signals in consequence of the slope of the second face of said active portion according to the Brewester angle and said first portion of optical fiber (12) is positioned on the same axis of said second focusing optical guide (6, 7). (figure 8).

14. Device according to claim 4, characterized by the fact that a glass made, wedge shaped portion (60) is located between said active portion (3) and said second focusing optical guide (6, 7).

15. Device according to claim 14 characterized by the fact that said wedge shaped portion (60) is made of active material. (figure 7).

16. Device according to claim 1, characterized by the fact that said second focusing optical guide consists of two segments of graded refraction index optical guide (6 and 7), and said air gap (8) is located between said two segments.

17. Device according to claim 1, characterized by the fact that said second focusing optical guide includes a sole element of graded refraction index optical guide (6-7), the air gap (8) being located between said active portion (3) and said graded refraction index optical guide element (6-7). (figure 7)

18. Device according to claims 1 to 17, characterized by the fact that said active medium is made of a glass matrix doped with Er:Yb and that λ2 is between 960 and 980 nm.

19. Device according to claims 1 to 17, characterized by the fact that said active medium consists of a glass matrix doped with Yb3 + (Pr) and that λ2 is between 960 and 980 nm.

20. Device according to claims 1 to 17, characterized by the fact that said active medium consists of a glass matrix doped with Cr3 + (Tm, Ho) and that λ2 is nearly 780 nm.

21. Device according to claims 1 to 17, characterized by the fact that said active medium consists of a crystalline matrix doped with Erbium, Er:CaF2.

22. Device according to claims 1 to 17, characterized by the fact that said active medium consists of a crystalline matrix doped with Erbium, Er:LiYF4.

23. Device according to claims 1 to 17, characterized by the fact that said active medium consists of a crystalline matrix doped with Neodymium, Nd:YAG.

24. Device according to claims 1 to 17, characterized by the fact that said active medium consists of a crystalline matrix doped with Neodymium, Nd:YLF.

25. Device according to claim 9, characterized by the fact that said single structure is supported by a submount (21) consisting of a single body at one end of which a raised portion (22) is foreseen on which the pumping laser (1) is welded, and at the other end a "V" shaped housing is foreseen inside of which is arranged and fixed said first portion of optical fiber (12), between said raised portion (22) and said "V" shaped housing (23), being foreseen a number of housings suitable to house said first portion of optical fiber (2), said active portion and said second focusing optical guide (6, 7). (figure 2).

26. Device according to claim 10, characterized by the fact that said single structure is positioned inside the female portion (40) of a connector for optical systems while one end of said second portion of optical fiber (30) is arranged inside the male portion (41) of said connector and the other end is optically coupled to the pumping laser (1) which is installed on a submount (43) housed inside a box body (42). (figure 4).

## Patentansprüche

1. Laservorrichtung, die als Dauerquelle für eine monochromatische Einmodenstrahlung mit einer ersten Wellenlänge λ1 im Bereich der Telekommunikation angewendet wird und welche folgendes umfaßt:
- einen Pumpdiodenlaser (1), der geeignet ist, eine Strahlung mit einer zweiten Wellenlänge λ2 < λ1 auszustrahlen;
- ein aktives Festkörpermedium (3), das geeignet ist, eine Strahlung mit der genannten ersten Wellenlänge λ1 abzugeben, welches mit dem genannten Pumplaser (1) durch einen ersten fokussierenden Lichtleiter (2, 30) verbunden ist, wobei zwischen der zweiten Seite des genannten fokussierenden Lichtleiters (2, 30) und der ersten Seite des genannten aktiven Mediums (3) ein erster Filter (4) angebracht ist, der im wesentlichen für die genannte Strahlung λ2 transparent ist und der die genannte Strahlung λ1 im wesentlichen reflektiert, und wobei auf der zweiten Seite des genannten aktiven Mediums (3) ein zweiter Filter (5) aufgetragen ist, der für die genannte Strahlung λ1 im wesentlichen transparent ist und der die genannte Strahlung λ2 im wesentlichen reflektiert;
- ein Etalon, das zwischen dem genannten ersten Filter (4) und einem dritten Filter (11) eingefügt ist, wobei letzterer Filter die Strahlung mit der genannten ersten Wellenlänge teilweise reflektiert;
dadurch charakterisiert, daß
- die genannte Laservorrichtung aus einer einzigen Struktur besteht, die auf eine Trägervorrichtung (21) montiert ist,
- das genannte Etalon wie ein Luftspalt (8) mit regulierbarer Weite geformt ist, welcher zwischen den genannten Filter (4) und den genannten dritten Filter (11) plaziert ist, wobei ein Glied in der genannten Trägervorrichtung (21) so gestaltet ist, daß die Weite des genannten Luftspalts (8) variiert werden kann;
- einem zweiter fokussierender Lichtleiter des abgestuften Indextyps (6, 7, 14), der aus mindestens einem ersten Teil besteht (6, 7), dessen erstes Ende optisch mit dem genannte zweiten Filter (5) gekoppelt ist, und dessen zweites Ende mit dem genannten dritten Filter (11) beschichtet ist; und einem ersten Teil der Lichtleitfaser (12), die mit dem genannten dritten Filter (11) oder mit einem zweiten Teil (14a) des zweiten fokussierenden Lichtleiters gekoppelt ist.

2. Vorrichtung nach Anspruch 1, dadurch gekennzeichnet, daß ein vierter und fünfter optischer Filter (9 beziehungsweise 10), welche die genannte Strahlung λ1 reflektieren, auf die gegenüberliegenden Seiten der Elemente aufgetragen sind, die den genannten Lichtspalt (8) bilden.

3. Vorrichtung nach Anspruch 1 oder 2, dadurch gekennzeichnet, daß die zweite Seite des genannte aktiven Mediums (3) hinsichtlich der ersten Seite im Winkel steht, wobei dieser Winkel (θB) einen Wert gleich annähernd 1° hat. (Abbildung 5)

4. Vorrichtung nach Anspruch 1 oder 2, dadurch gekennzeichnet, daß die zweite Seite des genannten aktiven Mediums (3) hinsichtlich der ersten Seite im Winkel steht, wobei dieser Winkel einen Wert gleich dem des Brewester Winkels hat. (Abbildung 6)

5. Vorrichtung nach Anspruch 1, dadurch gekennzeichnet, daß die genannte erste Seite des aktiven Mediums (3) abgerundet ist mit der konkaven Seite in Richtung der aktiven Masse.

6. Vorrichtung nach Anspruch 1, dadurch gekennzeichnet, daß die genannte erste Seite des aktiven Mediums (3) flach ist.

7. Vorrichtung entsprechend den Ansprüchen von 1 bis 6, dadurch gekennzeichnet, daß der genannte zweite fokussierende Lichtleiter (6, 7) aus einem Lichtleitersegment mit abgestuftem Brechungsindex besteht, dessen Länge ungefähr P/2 ist, wobei P der Fokussierabstand des Leitsegments ist.

8. Vorrichtung entsprechen den Ansprüchen von 1 bis 6, dadurch gekennzeichnet, daß der genannte zweite fokussierende Lichtleiter sich wie folgt zusammensetzt:
- aus einem Lichtleitersegment mit abgestuftem Brechungsindex (6, 7), dessen Länge annähernd P/4 ist, wobei P der Fokussierabstand des Leitersegments ist, und dadurch, daß der genannte dritte Filter (11) auf eine flache Seite des zweiten Endes dieses Segments aufgetragen ist; und aus:
- einem zweiten Lichtleitersegment mit abgestuftem Brechungsindex (14a) mit einer Länge von gleich etwa P/4;
- einer Antireflektierbeschichtung (15), welche auf die zweite Seite des zweiten Lichtleitersegments (14a) aufgetragen ist.

9. Vorrichtung entsprechend den Ansprüchen von 1 bis 6, dadurch gekennzeichnet, daß der erste fokussierende Lichtleiter aus einem Lichtleiterteil (2) mit abgestuftem Brechungsindex besteht, dessen Länge ungefähr P/2 ist, wobei P der Fokussierabstand des Leitersegments ist.

10. Vorrichtung nach den Ansprüchen 1 bis 6, dadurch gekennzeichnet, daß der erste fokussierende Lichtleiter aus einem zweiten Teil der Lichtleiterfaser (30) besteht. (Abbildung 3).

11. Vorrichtung entsprechend den Ansprüchen von 1 bis 10, dadurch gekennzeichnet, daß das genannte Glied zur Einstellung der Weite des Luftspalts (8) mit dem genannten zweiten fokussierenden Lichtleiter (6, 7) kombiniert ist und ein piezoelektrisches Element (13) einschließt, welches durch eine regulierbare Netzspannung (R, V) betrieben wird.

12. Vorrichtung nach Anspruch 4, dadurch gekennzeichnet, daß die Achse des genannten zweiten fokussierenden Lichtleiters (6, 7) die Achse des genannten aktiven Teils (3) anpaßt, und der genannte erste Teil der Lichtleiterfaser (12) weicht von der Achse des genannten zweiten fokussierenden Lichtleiter (6, 7) in einer Größenordnung (1) ab, die die Funktion des Winkels θB ist, mit dem die Lichtsignale aufgrund der Beugung der zweiten Seite des genannten aktiven Teils (3) entsprechend dem Brewester Winkels abweichen, und dadurch, daß der genannte zweite fokussierenden Lichtleiter (6, 7) eine Länge von ungefähr P/2 aufweist, wobei P der Fokussierabstand ist, und die zweite Seite ist flach (Abbildung 6).

13. Vorrichtung nach Anspruch 4, dadurch gekennzeichnet, daß die Achse des genannten fokussierenden Lichtleiters (6, 7) hinsichtlich der Achse des genannten aktiven Teils (3) im Winkel steht, wobei dieser Winkel gleich dem Winkel (θB) ist, der die Lichtsignale als Konsequenz der Beugung der zweiten Seite des genannten aktiven Teils entsprechend dem Brewester Winkel umleitet, und der genannte erste Abschnitt der Lichtleiterfaser (12) ist auf der selben Achse des genannten zweiten fokussierenden Lichtleiters (6, 7) angebracht.(Abbildung 8).

14. Vorrichtung entsprechend dem Anspruch 4, dadurch gekennzeichnet, daß ein aus Glas gefertigter keilförmiger Teil (60) zwischen dem genannten aktiven Teil (3) und dem genannten fokussierendem Lichtleiter (6, 7) plaziert ist.

15. Vorrichtung entsprechend dem Anspruch 14, dadurch gekennzeichnet, daß der genannte keilförmige Teil (60) aus aktiver Masse besteht (Abbildung 7).

16. Vorrichtung nach Anspruch 1, dadurch gekennzeichnet, daß der genannte zweite fokussierende Lichtleiter aus zwei Segmenten des Lichtleiters (6, 7) mit abgestuftem Brechungsindex besteht, und daß der Luftspalt (8) zwischen den beiden genannten Segmenten plaziert ist.

17. Vorrichtung nach Anspruch 1, dadurch gekennzeichnet, daß der genannte zweite fokussierende Lichtleiter ein einziges Element des Lichtleiters mit abgestuftem Brechungsindex (6, 7), den zwischen dem genannten aktiven Teil (3) und dem genannten Lichtleiterelement (6, 7) mit abgestuftem Brechungsindex plazierten Luftspalt (8) einschließt (Abbildung 7).

18. Vorrichtung entsprechend den Ansprüchen von 1 bis 17, dadurch gekennzeichnet, daß das genannte aktive Medium aus einer mit Er:Yb gedopten Glasmatrix besteht, und daß λ2 zwischen 960 und 980 nm liegt.

19. Vorrichtung nach den Ansprüchen von 1 bis 17, dadurch gekennzeichnet, daß das genannte aktive Medium aus einer mit Yb3 + (Pr) gedopten Glasmatrix besteht und daß λ2 zwischen 960 und 980 nm liegt.

20. Vorrichtung nach den Ansprüchen 1 bis 17, dadurch gekennzeichnet, daß das genannte aktive Medium aus einer mit Cr3 + (Tm, Ho) gedopten Glasmatrix besteht und daß λ2 circa 780 nm ist.

21. Vorrichtung nach den Ansprüchen 1 bis 17, dadurch gekennzeichnet, daß das genannte aktive Medium aus einer kristallinen mit Erbium, ER:CaF2 gedopten Matrix besteht.

22. Vorrichtung entsprechend den Ansprüchen von 1 bis 17, dadurch gekennzeichnet, daß das aktive Medium aus einer kristallinen mit Erbium, Er:LiYF4 gedopten Matrix besteht.

23. Vorrichtung nach den Ansprüchen von 1 bis 17, dadurch gekennzeichnet, daß das genannte aktive Medium aus einer kristallinen mit Neodymium, Nd:YAG gedopten Matrix besteht.

24. Vorrichtung nach den Ansprüchen von 1 bis 17, dadurch gekennzeichnet, daß das genannte aktive Medium aus einer kristallinen mit Neodymium, Nd:YLF gedopten Matrix besteht.

25. Vorrichtung nach Anspruch 9, dadurch gekennzeichnet, daß die genannte einzelne Struktur von einem Submount (21) getragen wird, der aus einem einzigen Körper besteht, an dessen einem Ende ein erhöhter Teil (22) vorgesehen ist, auf dem der Pumplaser geschweißt ist, und an dessen anderem Ende ein v-förmiges Gehäuse (23) vorgesehen ist, in dem der genannte erste Teil der Lichtleiterfaser (12) untergebracht und befestigt ist; zwischen dem genannte erhöhten Teil (22) und dem v-förmigen Gehäuse (23) ist eine Anzahl von Gehäusen vorgesehen, die geeignet sind, den genannte ersten Teil der Lichtleitfaser (2), den genannten aktiven Teil und den genannten zweiten fokussierenden Lichtleiter (6, 7) aufzunehmen. (Abbildung 2).

26. Vorrichtung entsprechend Anspruch 10, dadurch gekennzeichnet, daß die genannte einzelne Struktur innerhalb der Einsteckvorrichtung (40) eines Anschlußteils für optische Systeme plaziert ist, während ein Ende des zweiten Teils der Lichtleiterfaser (30) in der Steckervorrichtung (41) des genanten Anschlußstücks angeordnet ist, und das andere Ende ist optisch mit dem Pumplaser (1) gekoppelt, der auf einem Submount (43) im Innern eines Hohlkörpers (42) untergebracht ist. (Abbildung 4).

## Revendications

1. Dispositif laser pour l'emploi dans le secteur des télécommunications comme source continue d'une radiation monochromatique à mode unique avec une longueur d'onde λ1, qui comprend:
- un laser de pompage à diodes (1) apte à émettre une radiation avec une deuxième longueur d'onde λ2 < λ1;
- une portion solide active (3) apte à émettre une radiation avec la dite première longueur d'onde λ1, accouplée au dit laser de pompage (1) par un premier guide optique convergent (2, 30), entre la seconde face de la dite première portion de guide optique convergent (2, 30) et la première face du dit moyen actif (3) étant mis un premier filtre (4) essentiellement transparent à la dite radiation λ2 et essentiellement reflétant la dite radiation λ1, à la seconde face de la dite portion active (3) étant appliqué un deuxième filtre (5) essentiellement transparent pour la dite radiation λ1 et essentiellement reflétant la radiation λ2;
- un étalon interposé entre le dit filtre (4) et un troisième filtre (11) partiellement reflétant la radiation avec la dite première longueur d'onde λ1\
caractérisé par le fait que:
- le dit dispositif laser consiste en une seule structure montée sur des moyens de support (21),
- le dit étalon est formé comme un espace d'air (8) avec une largeur réglable, mis entre le dit premier filtre (4) et le dit troisième filtre (11), un membre (13) étant prévu dans le dit moyen de support (21) pour varier la largeur du dit espace d'air (8);
- un deuxième guide optique convergent du type index progressif (6, 7, 14) consistant en au moins une première portion (6, 7) dont la première extrémité est accouplée de manière optique au dit deuxième filtre (5) et dont la deuxième extrémité est revêtue par le dit troisième filtre (11); et une première portion de fibre optique (12) accouplée au dit troisième filtre (11) ou à une seconde portion (14a) du deuxième guide optique convergent.

2. Dispositif selon 1, caractérisé en ce que un quatrième et cinquième filtre (respectivement 9 et 10) reflétants la dite radiation λ1 sont appliqués aux faces opposées de l'élément formant le dit espace d'air (8).

3. Dispositif selon 1 ou 2, caractérisé en ce que la deuxième face du dit moyen actif (3) est inclinée par rapport à la première face d'un angle (θB), dont la valeur est approximativement 1°. (figure 5).

4. Dispositif selon 1 ou 2, caractérisé en ce que la deuxième face de la dite portion active (3) est inclinée par rapport à la première face d'un angle (θB), dont la valeur est égale à l'angle de Brewester. (figure 6)

5. Dispositif selon 1, caractérisé en ce que la dite première face de la portion active (3) est arrondie avec la part concave vers le matériel actif.

6. Dispositif selon 1, caractérisé en ce que la dite première face du moyen actif (3) est plane.

7. Dispositif selon les revendications de 1 à 6, caractérisé en ce que le deuxième guide optique convergent (6, 7) est composé d'un segment de guide optique (6, 7) avec un index de réfraction graduel, dont la longueur est approximativement P/2, P étant le pas de focalisation du segment de guide.

8. Dispositif selon les revendications de 1 à 6, caractérisé en ce que le dit deuxième guide optique convergent comprend:
- un segment de guide optique avec index de réfraction graduel (6, 7), dont la longueur est approximativement P/4, ou P est le pas de focalisation du segment de guide, et en ce que le dit troisième filtre (11) est appliqué à une face plane de la deuxième extrémité de tel segment;
et
- un deuxième segment de guide optique avec index de réfraction graduel (14a) ayant une longueur égale à approximativement P/4;
- une couche antireflétante (15) appliquée sur la deuxième face du deuxième segment du guide optique (14a).

9. Dispositif selon les revendications de 1 à 6, caractérisé en ce que le dit premier guide optique convergent consiste en une portion de guide optique (2) avec index de réfraction graduel, dont la longueur est approximativement P/2, ou P est le pas de focalisation du segment guide.

10. Dispositif selon les revendications de 1 a 6, caractérisé en ce que le dit premier guide optique convergent consiste en une deuxième portion de fibre optique (30). (figure 3).

11. Dispositif selon les revendications de 1 à 10, caractérisé en ce que le dit corps pour régler la largeur du dit espace d'air (8) est combiné au dit deuxième guide optique convergent (6, 7) et comprend un élément piézoélectrique (13), alimenté par un voltage réglable (R, V).

12. Dispositif selon 4, caractérisé en ce que l'axe du dit deuxième guide optique convergent (6, 7) coïncide avec l'axe de la dite portion active (3) et dite première portion de fibre optique dévie de l'axe du dit deuxième guide optique convergent (6, 7) d'une entité (1), qui est fonction de l'angle (θD), duquel des signaux optiques devient en conséquence de l'angle de la deuxième face de la dite portion active (3) selon l'angle de Brewester, et par le fait, que le dit deuxième guide optique convergent (6, 7) a presque une longueur P/2, P étant le pas de focalisation, et la deuxième face est plane (figure 6).

13. Dispositif selon 4, caractérisé en ce que l'axe du deuxième guide optique convergent (6, 7) est incliné par rapport à l'axe de la dite portion active (3) par un angle égal à l'angle (θD) déviant les signaux optiques en conséquence de l'inclinaison de la deuxième face de la dite portion active selon l'angle de Brewester, et la dite première portion de fibre optique (12) est positionnée sur la même axe du dit deuxième guide optique convergent (6, 7). (figure 8).

14. Dispositif selon 4, caractérisé en ce que entre la dite portion active (3) et la dite deuxième portion de guide optique convergent une portion cunéiforme (60) de verre est placée.

15. Dispositif selon 14, -caractérisé en ce que le dite portion cunéiforme (60) consiste en matériel actif. (figure 7).

16. Dispositif selon 1, caractérisé en ce que le dit deuxième guide optique convergent consiste en deux segments de guide optique à index de réfraction graduel (6, 7), et le dit espace d'air (8) est placé entre les dits segments.

17. Dispositif selon 1, caractérisé en ce que le dit deuxième guide optique convergent comprend un seul élément de guide optique à index de réfraction graduel (6, 7), l'espace d'air étant placé entre la dite portion active (3) et l'élément de guide optique à index de réfraction graduel (6, 7). (figure 7).

18. Dispositif selon le revendications de 1 à 17, caractérisé en ce que la portion active consiste en une matrice de verre dopé avec ER:Yb et que λ2 est compris entre 960 et 980 nm.

19. Dispositif selon les revendications de 1 à 17, caractérisé en ce que le dit moyen actif consiste en une matrice de verre dopé avec Yb3 + (Pr) et que λ2 est compris entre 960 et 980 nm.

20. Dispositif selon les revendications de 1 à 17, caractérisé en ce que le dit moyen actif consiste en une matrice de verre dopé avec Cr3 + (Tm, Ho) et que λ2 est à peu près 780 nm.

21. Dispositif selon le revendications de 1 à 17, caractérisé en ce que le dit moyen actif consiste en une matrice cristalline dopée de Erbium, Er:CaF2.

22. Dispositif selon les revendications de 1 à 17, caractérisé en ce que le dit moyen actif consiste en une matrice cristalline dopée de Erbium, Er:LiYF4.

23. Dispositif selon les revendications de 1 à 17, caractérisé en ce que le dit moyen actif consiste en une matrice cristalline dopée de Neodymium, Nd:YAG.

24. Dispositif selon les revendications de 1 à 17, caractérisé en ce que le moyen actif consiste en une matrice cristalline dopée de Neodymium, Nd:YLF.

25. Dispositif selon la revendication 9, caractérisé en ce que la dite structure unique est supportée par un moyen de support (21), qui consiste en un corps unique à l'extrémité duquel une portion élevée (22) est prévue, sur laquelle le laser pompant (1) est soudé, et à l'autre extrémité est prévu un siège à forme de V, dans lequel est arrangée et fixée la dite portion de fibre optique (12), entre la dite portion élevée (22) et le dit siège à forme de V (23) étant prévue une pluralité de sièges aptes à accueillir la dite première portion de fibre optique (2), la dite portion active et le dit deuxième guide optique convergent (6, 7). (figure 2).

26. Dispositif selon la revendication 10, caractérisé en ce que la dite structure unique est positionnée à l'intérieur de la portion féminine (40) d'un connecteur pour des systèmes optiques, pendant que une extrémité de la dite deuxième portion de fibre optique (30) est arrangée à l'intérieur de la portion masculine (41) du dit connecteur et l'autre extrémité est accouplée de manière optique au laser pompant (1), qui est installé sur un moyen de support (43) placé à l'intérieur d'un corps à forme de boîte (42). (figure 4).
